# EUROPEAN PATENT APPLICATION

(11) **EP 1 193 502 A2**
(43) Date of publication of application: **03.04.2002**
(21) Application number: 01307938.9
(22) Date of filing: 18.09.2001
(51) Int. Cl.: G01R 31/3181

(54) **Apparatus and method for performing conditional calculations**

(30) Priority: 29.09.2000 US 676188
(71) Applicant: Agilent Technologies, Inc., Palo Alto, CA 94306 (US)
(72) Inventor: Krech, Alan S., Jr., Fort Collins, CO 80525 (US); Jordan, Stephen D., Fort Collins, CO 80528 (US); Freeseman, John M., Fort Collins, CO 80526 (US); Wong, Samuel U., Cupertino, CA 95014 (US); De La Puente, Edmundo, Cupertino, CA 95014 (US)
(74) Representative: Jackson, Richard Eric

(57) **Abstract**

A tester is able to perform complex conditional calculations within a single vector cycle. The tester has arithmetic elements 24 to perform calculations, each arithmetic element including, among other things, an arithmetic logic unit of conventional design. Status flags 306 within the tester reflect a current state of the tester. Execution of an instruction 370, 372 to one or more of the arithmetic elements 302 may be conditioned upon one of the status flags 306. One of the status flags 306 is chosen by a status flag selector 360 based upon a programmed condition 364. The chosen status flag 306 is used to determine which one of first and second alternative instructions 370,372 is chosen for presentation as an output of an instruction selector 368 to the arithmetic element 302.

A tester includes a method for performing conditional calculations within a single test vector cycle that first generates status flags 306 reflecting a current status of the tester. One of said status flags 306 is selected as an instruction select 366. First and second alternative instructions are presented to an instructions selector 368 and the instruction select 366 determines which one of the first and second instructions is selected for execution by an arithmetic unit 302.

## Description

### Background

Electronics devices and capabilities have grown extremely common in daily life. Along with personal computers in the home, many individuals carry more than one productivity tool for various and sundry purposes. Most personal productivity electronic devices include some form of non-volatile memory. Cell phones utilize non-volatile memory in order to store and retain user programmed phone numbers and configurations when the power is turned off. PCMCIA cards utilize non-volatile memory to store and retain information even when the card is removed from its slot in the computer. Many other common electronic devices also benefit from the long-term storage capability of non-volatile memory in un-powered assemblies.

Non-volatile memory manufacturers that sell to the electronic equipment manufacturers require testers to exercise and verify the proper operation of the memories that they produce. Due to the volume of non-volatile memories that are manufactured and sold at consistently low prices, it is very important to minimize the time it takes to test a single part. Purchasers of non-volatile memories require memory manufacturers to provide high shipment yields because of the cost savings associated with the practice of incorporating the memory devices into more expensive assemblies with minimal or no testing. Accordingly, the memory testing process must be sufficiently efficient to identify a large percentage of non-conforming parts and preferably all non-conforming parts in a single test process.

As non-volatile memories become larger, denser and more complex, the testers must be able to handle the increased size and complexity without significantly increasing the time it takes to test them. As memories evolve and improve, the tester must be able to easily accommodate the changes made to the device. Another issue specific to testing non-volatile memories is that repeated writes to cells of the memories can degrade the overall lifetime performance of the part. Non-volatile memory manufacturers have responded to many of the testing issues by building special test modes into the memory devices. These test modes are not used at all by the purchaser of the memory, but may be accessed by the manufacturer to test all or significant portions of the memories in as little time as possible and as efficiently as possible. Some non-volatile memories are also capable of being repaired during the test process. The tester, therefore, should be able to identify: a need for repair; a location of the repair; the type of repair needed; and, must then be able to perform the appropriate repair. Such a repair process requires a tester that is able to detect and isolate a specific nonconforming portion of the memory. In order to take full advantage of the special test modes as well as the repair functions, it is beneficial for a tester to be able to execute a test program that supports conditional branching based upon an expected response from the device.

From a conceptual perspective, the process of testing memories is an algorithmic process. As an example, typical tests include sequentially incrementing or decrementing memory addresses while writing 0's and 1's into the memory cells. It is customary to refer to a collection of 1's and 0's being written or read during a memory cycle as a "vector", while the term "pattern" refers to a sequence of vectors. It is conventional for tests to include writing patterns into the memory space such as checkerboards, walking 1's and butterfly patterns. A test developer can more easily and efficiently generate a program to create these patterns with the aid of algorithmic constructs. A test pattern that is algorithmically coherent is also easier to debug and use logical methods to isolate portions of the pattern that do not perform as expected. A test pattern that is generated algorithmically using instructions and commands that are repeated in programming loops consume less space in tester memory. Accordingly, it is desirable to have algorithmic test pattern generation capability in a memory tester.

Precise signal edge placement and detection is also a consideration in the effectiveness of a non-volatile tester. In order to capture parts that are generally conforming at a median while not conforming within the specified margins, a non-volatile memory tester must be able to precisely place each signal edge relative in time to another signal edge. It is also important to be able to precisely measure at which point in time a signal edge is received. Accordingly, a non-volatile memory tester should have sufficient flexibility and control of the timing and placement of stimuli and responses from the Device Under Test (memory).

Memory testers are said to generate transmit vectors that are applied (stimulus) to the DUT, and receive vectors that are expected in return (response). The algorithmic logic that generates these vectors can generally do so without troubling itself about how a particular bit in a vector is to get to or from a particular signal pad in the DUT. At this level it is almost as if it were a certainty that adjacent bits in the vector would end up as physically adjacent signals on the DUT. Life should be so kind!

In reality, the correspondence between bits in a vector at the "conceptual level" and the actual signals in the DUT is apt to be rather arbitrary. If nothing were done to prevent it, it might be necessary to cross one or more probe wires as they descend from a periphery to make contact with the DUT. Such crossing is most undesirable, and it is convention to incorporate a mapping mechanism in the path of the transmit vector to rearrange the bit positions in the transmit vector before they are applied to the DUT, so that task of making physical contact is not burdened with crossings. Receive vectors are correspondingly applied to a reverse mapping mechanism before being considered. In this way the algorithmic vector generation and comparison mechanisms can be allowed to ignore this entire issue. As another example of what such mappers and reverse mappers can do, consider the case when a different instance of the same type of DUT is laid out on the same wafer, but with a rotation or some mirrored symmetry, in order to avoid wasting space on the wafer. These practices also have an effect on the correspondence between vector bit position and physical signal location, but which can be concealed by the appropriate mappings and reverse mappings. It will be appreciated that the mappings and reverse mappings needed for these situations are, once identified for a particular DUT, static, and need not change during the course of testing for that particular DUT.

Conditional calculation capabilities significantly enhance algorithmic pattern generation. Specifically, the ability to perform calculations based upon the current state of one or more flags permit the test developer to create a test pattern that generates a complex pattern using a minimum number of vectors. Historically, multiple and complex conditions are processed in software providing a great amount of flexibility. In a memory tester, however, it is important to apply each vector in the pattern to the DUT while maintaining precise and predictable timing. Evaluating multiple and complex conditions using a software based approach can compromise the integrity of predictable vector timing or slow the rate with which a tester is able to reliably apply vectors at speed. There is a need, therefore, for an apparatus to quickly perform multiple calculations based upon multiple and complex conditions in a tester without compromising the ability of the tester to drive and receive test vectors at speed.

### Summary

An apparatus for performing conditional calculations has an arithmetic element and an instruction selector. The instruction selector receives a plurality of instructions. The apparatus also has a plurality of status flags that reflect a state of the apparatus and a status flag selector that selects one of the status flags. The selected status flag becomes an instruction select and the instruction select determines which one of the plurality of instructions is executed by the arithmetic element.

A process for performing conditional calculations generates a plurality of status flags and selects one of the status flags as an instruction select. First and second alternative instructions are presented to an instruction selector, one of the first and second instructions being selected for execution by an arithmetic unit. The instruction select determines the selection of either the first or second instructions for execution by the arithmetic element.

### Brief Description of the Drawings

Figure 1 is a simplified block diagram of an extensively reconfigurable non-volatile memory tester constructed in accordance with the invention.
Figure 2 is a simplified block diagram expansion of the DUT tester 6 of Figure 1.
Figures 3-4 are block diagrams of logic according to the teachings of the present invention that permit conditional computation for three arithmetic elements.
Figure 5 is a block diagram of logic according to the teachings of the present invention that permits conditional computations and mask comparison for two arithmetic elements .
Figures 6-7 are block diagrams of logic according to the teachings of the present invention that permit conditional computations for three arithmetic elements.
Figure 8 is a simplified block diagram of the component parts of an embodiment according to the teachings of the present invention for each arithmetic element represented in Figures 3-7.
Figures 9 through 12 represent an embodiment according to the teachings of the present invention of the binary words for encoding the block diagrams shown in Figures 3-8 to perform complex conditional calculations.
Figure 13 shows a specific embodiment of a Perl regular expression used in a compiler according to the teachings of the present invention.

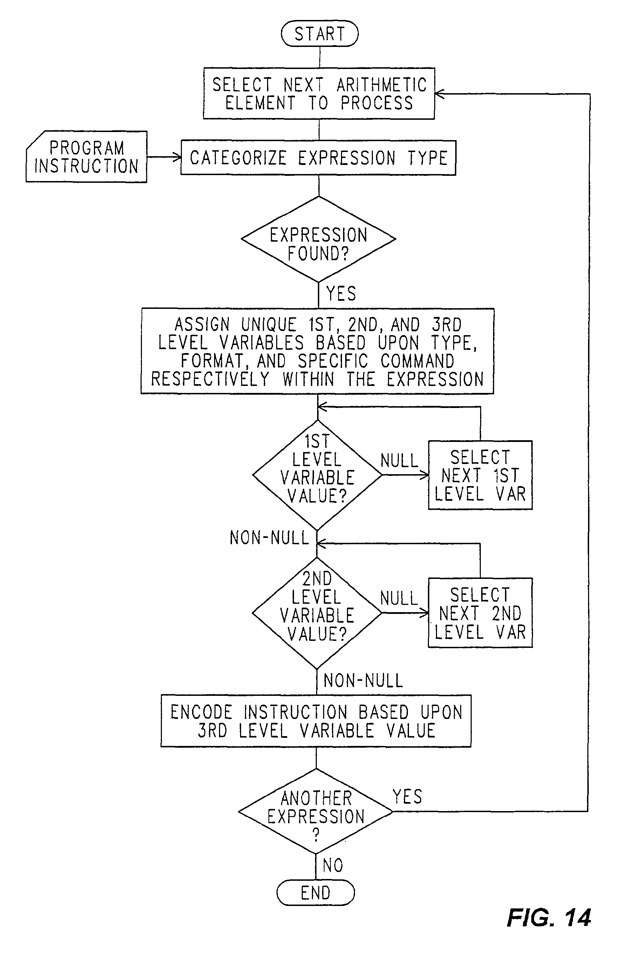

Figure 14 is a flow chart of a compiler process according to the teachings of the present invention.

### Detailed Description

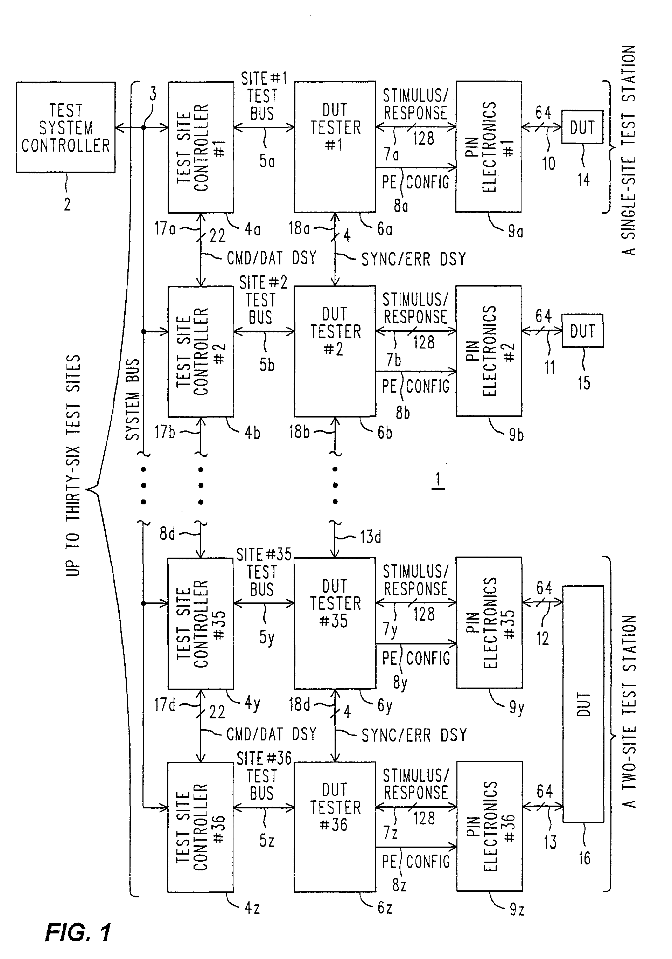

Refer now to Figure 1, wherein is shown a simplified block diagram 1 of a Non-Volatile Memory Test System constructed in accordance with the principles of the invention. In particular, the system shown can simultaneously test, with as many as sixty-four test points each, up to thirty-six individual DUT's (Devices Under Test) at one time, with provisions for reconfiguration to allow elements of a collection of test resources to be bonded together to test DUT's having more than sixty-four test points. These test points may be locations on a portion of an integrated circuit wafer that has not yet been diced and packaged, or they might be the pins of a packaged part. The term "test point" refers to an electrical location where a signal may be applied (e.g., power supplies , clocks, data inputs) or where a signal can be measured (e.g., a data output). We shall follow the industry custom of referring to the test points as "channels". The "collection of test resources to be bonded together" referred to above may be understood as being as many as thirty-six test sites, where each test site includes a Test Site Controller (4), a (sixty-four channel) DUT Tester (6) and a (sixty-four channel) collection of Pin Electronics (9) that makes actual electrical connection to a DUT (14). In the case where testing the DUT requires sixty-four or fewer channels, a single Test Site is sufficient to perform tests upon that DUT, and we say, for example, that the Test Site #1 (as it appears in Figure 1) forms or operates as a "Single Site Test Station". On the other hand, when some form of the aforementioned reconfiguration is in effect, two (or more) Test Sites are "bonded" together to function as one larger equivalent Test Site having one hundred and twenty-eight channels. Accordingly, and again in reference to an example shown in Figure 1, we say that Test Sites #35 and #36 form a "two-Site Test Station".

To briefly consider the opposite case, one should not assume that an entire Test Site is needed to test a single DUT, or that a single Test Site can test but a single DUT. Suppose that a wafer had two (probably, but not necessarily, adjacent) dies, the sum of whose test channel requirements were sixty-four channels or less. Both DUT's can be tested by a single Test Site. What makes this possible is the general purpose programmability of each Test Site. A test program executed by the Test Site may be written such that one part of the Test Site's resources is used to test one of the DUT's while another part is used to test the other DUT. After all, we would assume that if we had a third DUT that were the logical union of the first two, then we would be able to test that third DUT with a single Test Site, so we ought to be able to similarly test its "component DUT's", as it were. The only difference is individually keeping track of whether the two "component DUT's" pass or fail, as opposed to a unified answer for the "third" DUT (that is, there is an issue concerning what portion of the "third" DUT failed). This "Single-Site Multi-Test Station" capability is largely conventional, and we mention it here for the sake of completeness, and to ward off potential confusion and misunderstanding when comparing it to the notion of bonding two or more Test Sites together.

Were it not for this notion of reconfiguration there would be no difference between a Test Site and a Test Station, and we would dispense with one of the terms. As it is, however, it will be readily appreciated that the number of Test Stations need not equal the number of Test Sites. In the past, the numbers could be different because Test Sites were split to create more Test Stations (DUT's not complex enough to consume an entire Test Site). Now, however, the difference may also be due to Test Sites having been bonded together to form multi-site Test Stations (DUT's too complex for a single Test Site).

To continue, then, a Test System Controller 2 is connected by a System Bus 3 to as many as thirty-six Test Site Controllers whose names end in the suffixes #1 through #36 (4a-4z). (It is true that subscripts a-z only go from one to twenty-six, and not to thirty-six. But this minor deception seems preferable over numerical subscripts on numerical reference characters, which would be potentially very confusing.) The Test System Controller 2 is a computer (e.g., a PC running NT) executing a suitable Test System Control Program pertaining to the task of testing non-volatile memories. The Test System Control Program represents the highest level of abstraction in a hierarchical division of labor (and of complexity) for accomplishing the desired testing. The Test System Controller determines which programs are being run by the different Test Sites, as well as overseeing a robotics system (not shown) that moves the test probes and DUT's as needed. Test System Controller 2 may function in ways that support the notion that some Test Sites are programmed to perform as single-site Test Stations, while others are bonded together to form multi-site Test Stations. Clearly, in such circumstances there are different parts being tested, and it is most desirable that different tests be used for the different parts. Likewise, there is no requirement that all single-site Test Stations be testing the same style of part, nor is there any such requirement for multi-site Test Stations. Accordingly, the Test System Controller 2 is programmed to issue the commands to accomplish the needed Test Site bonding and then to invoke the appropriate test programs for the various Test Stations in use. The Test System Controller 2 also receives information about results obtained from the tests, so that it may take the appropriate action for discarding the bad part and so that it may maintain logs for the various analyses that may be used to control, say, production processes in a factory setting.

The Test System itself is a fairly large and complex system, and it is common for it to use a robotics subsystem to load wafers onto a stage that then sequentially positions one or more future dies under probes connected to the Pin Electronics 9, whereupon those future dies (the wafer has not yet been diced) are tested. The Test System can also be used to test packaged parts that have been loaded onto a suitable carrier. There will be (as is explained below), at least one Test Site Controller associated with each Test Station in use, regardless of how many Test Sites are used to form that Test Station, or of how many Test Stations are on a Test Site. A Test Site Controller is an embedded system that may be an i960 processor from Intel with thirty-six to sixty-four MB of combined program and data memory running a proprietary operating system called VOS (VersaTest O/S), which was also used in earlier products for testing non-volatile memories (e.g., the Agilent V1300 or V3300). For the moment, we shall consider only the situation for single-site Test Stations. For the sake of a definite example, suppose that Test Site #1 is functioning as Test Station #1, and that it is to test the WHIZCO part no. 0013. The test regimen involves a hundred or so different types of tests (varying and monitoring voltage levels, pulse widths, edge positions, delays, as well as a large dose of simply storing and then retrieving selected patterns of information), and each type of test involves many millions of individual memory cycles for the DUT. At the highest level, the operators of the Test System instruct the Test System Controller 2 to use Test Station #1 to begin testing WHIZCO 0013's. In due course the Test System Controller 2 tells Test Site Controller #1 (4a) (which is an embedded [computer] system) to run the associated test program, say, TEST_WHIZ_13. If that program is already available within Test Site Controller #1's environment, then it is simply executed. If not, then it is supplied by the Test System Controller 2.

Now, in principle, the program TEST_WHIZ_13 could be entirely self-contained. But if it were, then it would almost certainly be rather large, and it may be difficult for the processor of the embedded system within the Test Site Controller 4a to run fast enough to produce the tests at the desired speed, or even at a rate that is uniform from one DUT memory cycle to the next. Accordingly, low level subroutine type activities that generate sequences of address and associated data that is to be written or is expected from a read operation, are generated as needed by a programmable algorithmic mechanism located in the DUT Tester 6, but that operates in synchrony with the program being executed by the embedded system in the Test Site Controller 4. Think of this as exporting certain low level subroutine-like activity and the task of initiating DUT memory cycles out to a mechanism (the DUT Tester) that is closer to the hardware environment of the DUT 14. Generally speaking, then, whenever the Test System Controller 2 equips a Test Site Controller with a test program it also supplies the associated DUT Tester with appropriate low level implementation routines (perhaps specific to the memory being tested) needed to accomplish the overall activity described or needed by the programming for the Test Site Controller. The low level implementation routines are termed "patterns", and they are generally named (just as functions and variables in high level programming languages have names).

Each Test Site Controller #n (4) is coupled to its associated DUT Tester #n (6) by a Site Test Bus #n (5). The Test Site Controller uses the Site Test Bus 5 to both control the operation of the DUT Tester and receive therefrom information about test outcomes. The DUT Tester is capable of generating at high speed the various DUT memory cycles that are involved in the test regimen, and it decides if the results of a Read memory cycle are as expected. In essence, it responds to commands or operation codes ("named patterns") sent from the Test Site Controller by initiating corresponding useful sequences of Read and Write DUT memory cycles (i.e., it executes the corresponding patterns). Conceptually, the output of the DUT Tester 6 is stimulus information that is to be applied to the DUT, and it also accepts response information therefrom. This stimulus/response information 7a passes between the DUT Tester 6a and a Pin Electronics #1 assembly 9a. The Pin Electronics assembly 9a supports up to sixty-four probes that can be applied to the DUT 14.

The above-mentioned stimulus information is just a sequence of parallel bit patterns (i.e., a sequence of "transmit vectors" and expected "receive vectors") expressed according to the voltage levels of some family of logic devices used in the DUT Tester. There is a configurable mapping between bit positions within a stimulus/response and the probes on the die, and this mapping is understood by the DUT Tester 6. The individual bits are correct as to their timing and edge placement, but in addition to the mapping they may also need voltage level shifting before they can be applied to the DUT. Likewise, a response that originates in the DUT subsequent to a stimulus may need buffering and (reverse) level shifting before it can be considered suitable for being fed back to the DUT Tester. These level shifting tasks are the province of the Pin Electronics 9a. The Pin Electronics configuration needed for testing a WHIZCO 0013 likely will not work for testing a part from the ACME Co., and perhaps not even with another WHIZ Co. part. So, it will be appreciated that the Pin Electronics assembly needs to be configurable also; such configurability is the function of the PE Config lines 8a.

The above concludes a brief architectural overview of how a single Test Site is structured for testing a DUT. We turn now to issues that arise when there are many Test Sites with which to operate. As a preliminary, we shall describe a preferred embodiment for constructing a Test System having multiple Test Sites. In many respects, some of the information we are about to describe are matters of choice based on market studies of customer preference and cost benefit analyses. Be that as it may, to build one of these things one has to make definite choices, and once that is done there are particular consequences that are visible throughout the entire system. It is felt that it is useful to describe, at least in a general way, the larger outlines of the hardware properties of the Test System. Even though some of these properties are contingent, a knowledge of them will nevertheless assist in an appreciation of various examples used to illustrate the invention.

To begin, then, consider four rather large card cages. Each card cage has, besides power supplies and water cooling (fans can be a source of contamination in a clean room environment), a mother board, a front plane and a back plane. Into each card cage can be placed up to nine assemblies. Each assembly includes a Test Site Controller, DUT Tester and Pin Electronics. We shall be describing the general outlines of how Test Site Controllers are bonded together, which will involve some busses used to create daisy chains.

A brief digression concerning the term "daisy chain" is perhaps in order. Consider system elements A, B, C and D. Suppose that they are to be daisy chained together in that order. We could say that there is an information or control path that leaves A and goes into B, that B can selectively pass on traffic that then leaves B and goes into C, and that C can selectively pass on traffic that then goes into D. These same kind of arrangements can exist for traffic in the other direction, too. Daisy chains are often used to create priority schemes; we shall use them to create master/slave relationships between various the Test Site Controllers. We shall denote these daisy chained style communication arrangements with the suffix noun "DSY", instead of "BUS". Thus, we might refer to a Command /Data DSY instead of a Command/Data Bus. Now, the notion that information "enters B and is selectively passed on" may suggest that traffic is replicated onto a separate set of conductors before being passed on. It could be that way, but for performance reasons it is more like a regular bus having addressable entities. By means of a programmable address mapping arrangement and the ability to put portions of downstream Test Site Controllers "to sleep," the single bus can be made to logically appear (i.e., to function) as a plurality of daisy chains. Finally, it will be appreciated that the daisy chains are high performance pathways for command and control information, and that if they were not, then we could not expect a master/slave combination (multi-site Test Station) to operate as fast as a single Test Site does. For the benefit of daisy chain performance, the various DSY do not leave their respective card cages. The effect of this decision is to place some limits on which Test Sites (and thus also how many) can be bonded together. In principle, there is no fundamental need for this limitation, nor is there a genuine lack of technical practicality involved (it could be done); it is simply felt that, since there are already nine Test Sites in a card cage, extending the DSY's adds significant cost for relatively little additional benefit.

To resume our discussion of Figure 1, then, consider the various Test Site Controllers 4a-4z that can populate the four card cages, each with nine Test Site Controllers. Let's denote them as 4a-4f, 4g-4m, 4n-4t and 4u-4z. (Never minding, as explained earlier, that these are nominally only twenty-six subscripts -- the reader is invited to imagine that there are another ten subscript symbols in there, someplace.) A CMD/DAT DSY 17a (Command & Data Daisy Chain) interconnects the Test Site Controller 4a-4f that are in one card cage, while a different CMD/DAT DSY 17b interconnects the Test Site Controllers 4g-4m in another card cage. The same arrangement exists for the remaining card cages, and Test Site Controllers 4n-4t and 4u-4z, respectively. We have earlier said that the DSY do not leave the card cages, in that "tail end" of a bus that actually forms the DSY does not leave a card cage and become the head of the next segment in another card cage. Instead, the System Bus 3 from the Test System Controller 2 goes to all Test Site Controllers, and each is capable of becoming a Master at the head of a DSY segment that does not leave the card cage.

The CMD/DAT DSY 17a-d that we have been discussing exist between the various Test Site Controllers 4a-4z. There is a similar arrangement for the SYNC/ERR DSY 18a-18d and the DUT Testers 6a-6z. The synchronization and error information conveyed by the SYNC/ERR DSY 18 allows DUT Testers to function in unison. These two daisy chains (17 and 18) carry slightly different types of information, but each exists as part of the same general mechanism for bonding one or more Test Sites together into a Test Station.

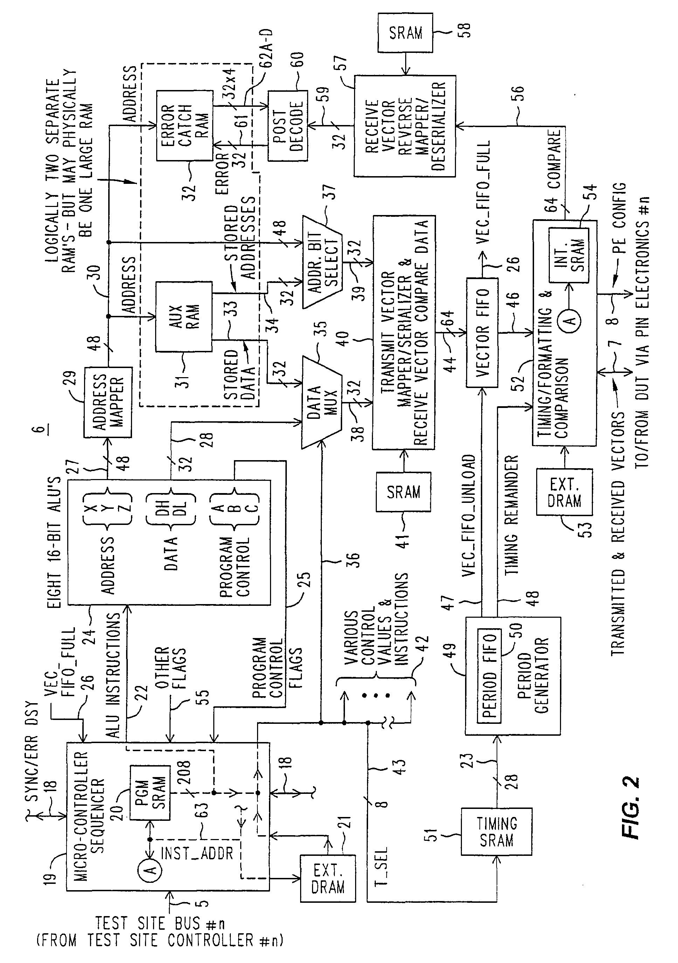

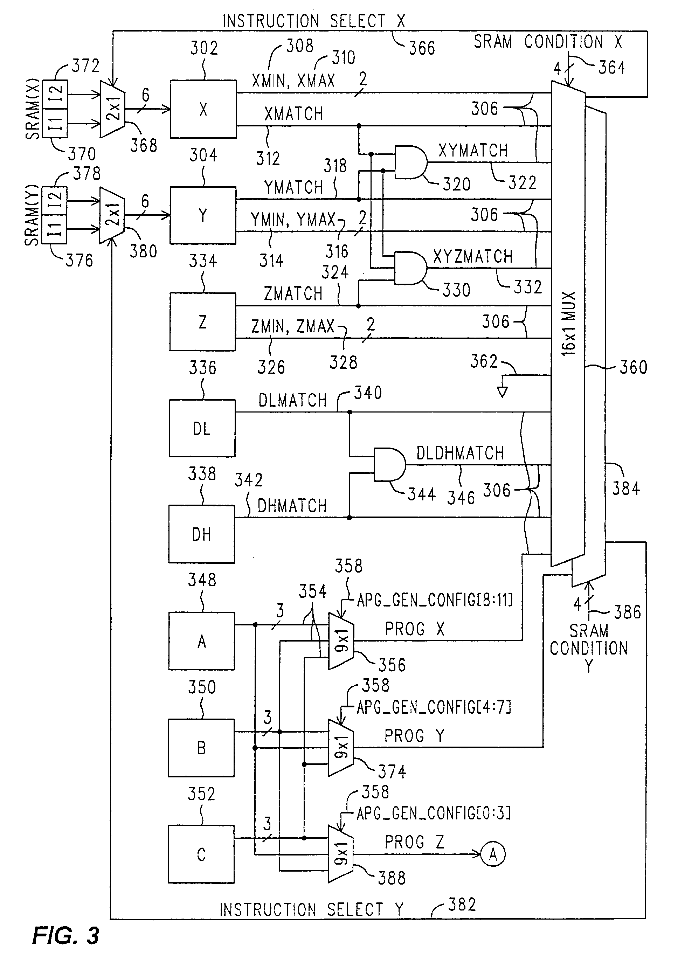

We turn now to a discussion of Figure 2, which is a simplified block diagram expansion of the DUT tester 6 of Figure 1, of which there may be as many as thirty-six. It is sufficient at present to describe only one instance thereof. A glance at Figure 2 will show that it is a fairly well populated with stuff; especially so for a "simplified" block diagram. Some of what is in the DUT Tester 6 and represented in the block diagram is functionally quite complicated, and is not available in "off the shelf' form. It is appropriate here to make two points. First, the primary purpose of including Figure 2 is to describe the basic properties of an important operational environment within the overall Non-Volatile Memory Test System 1. The invention(s) that are fully described in connection with Figure 3 and subsequent figures will either be expansions of mechanisms set out in the following description of Figure 2, or they will be new mechanisms whose motivational premise is found in Figure 2. Either way, as this is written it is not known exactly which of these is before the reader. The goal at present is to provide a simplified yet informative starting point for numerous different Detailed Descriptions of various Preferred Embodiments, so that each of those can be as concise as is appropriate (as opposed to one "jumbo" Specification that discloses everything about each different invention). The second point is that the expanded or extended material, while in general overall agreement with Figure 2, may contain information that does not "match-up" exactly with the simplified version. This does not mean there has been an error, or that things are fatally inconsistent; it arises because it is sometimes difficult or impossible to simplify something such that it is the exact image in miniature. The situation is rather like maps. A standard size road map of Colorado will show that when going east on I-70 you can go north on I-25 at Denver. It looks like a left turn. And while it did used to be an actual left turn, it isn't one now, and a detailed map of that intersection will show a sequence of component turns and intervening road sections. But no one would say that the standard size road map is wrong; it is correct for its level of abstraction. Similarly, and despite its fairly busy appearance, Figure 2 is indeed a simplification operating at a medium level of abstraction, but some seeming left turns are not simple left turns at all.

As is shown in Figure 1, the major input to the DUT Tester 6 is an instance of the Test Site Bus 5, which originates from a Test Site Controller 4 that is associated with the instance of the DUT Tester 6 that is of interest. The Test Site Bus 5 is coupled to a Micro-Controller Sequencer 19, which may be likened to a special purpose microprocessor. It fetches instructions from a program stored in a program memory, which may be either internal to the Micro-Controller Sequencer 6 (PGM SRAM 20) or external thereto (EXT. DRAM 21). Although these two memories appear to be addressed by what is essentially a logically common address 63 that serves as a program counter (or, instruction fetch address), and either can be a source of programming to be executed, note that: (1) Only one of the memories performs instruction fetch memory cycles during any period of time; and (2) In fact they are addressed by electrically different signals. The SRAM is fast and allows genuine random access, but consumes valuable space within the Micro-Sequence Controller 19 (which is a large IC), so its size is limited. The external DRAM can be provided in adjustable amounts of considerable quantity, but is fast only when accessed in sequential chunks involving linear execution and no branching. Programming in the SRAM 20 most often that which is intensely algorithmic, while the EXT. DRAM 21 is best suited for material not readily generated by algorithmic processes, such as initialization routines and random or irregular data.

The instruction word executed by the Micro-Controller Sequencer 19 is fairly wide: two hundred and eight bits. It consists of thirteen sixteen-bit fields. These fields often represent fetched instruction information for mechanisms that are outside the Micro-Controller Sequencer proper. Such fields are dedicated to their associated mechanisms. One set of ALU INSTRUCTIONS 22 are applied to a collection of eight sixteen-bit ALU's 24, while others are disbursed to various other mechanisms distributed throughout the DUT Tester. This latter situation is represented by the lines and legend "VARIOUS CONTROL VALUES & INSTRUCTIONS" 42.

The eight sixteen-bit ALU's (24) each have a conventional repertoire of arithmetic instructions built around associated sixteen-bit result registers (each ALU has several other registers, too). Three of these result registers and their associated ALU's are for generating X, Y and Z address components 27 that are variously combined into a complete address to supplied to the DUT. Two more of the eight ALU/registers (DH & DL) are provided to assist in the algorithmic creation of thirty-two bit data patterns 28 that are divided between a most significant portion (DH) and a least significant portion (DL). A final three ALU/registers (A, B, C) are used as counters and contribute to the production of various PROGRAM CONTROL FLAGS 25 that assist with program control and branching on completion of some programmatically specified number of iterations or other numerical condition. These PROGRAM CONTROL FLAGS 25 are sent back to the Micro-Controller Sequencer 19, where they affect the value of the instruction fetch address in ways familiar to those who understand about microprocessors. There are also various OTHER FLAGS 55 that also can be used to effect program branching. These originate with various ones of the other mechanisms within the DUT Tester 6 that are controlled by the different fields of the fetched instruction word. One specific additional flag is expressly shown as a separate item: VEC_FIFO_FULL 26. In another drawing having somewhat less detail it might be lumped in along with the OTHER FLAGS 55. We have separated it out to assist in explaining one aspect of the operation of the Micro-Controller Sequencer 19.

What VEC_FIFO_FULL does is to (temporarily) halt further program execution by the Micro-Controller Sequencer 19. There are many stages of pipeline between the instructions fetched by the Micro-Controller Sequencer 19 and the mechanism that finally hands test vectors off to be applied to the DUT. In addition, part of the baggage that accompanies a vector as it moves toward being applied to the DUT is information concerning the rate of eventual vector application, or, each vector's duration. Thus, the rate of vector application to the DUT need not be constant, and in particular, a group of vectors may take longer to apply than they did to generate. The Micro-Controller Sequencer simply executes programming at its maximum rate. But clearly, on average, the rate of "vector consumption," as it were, must equal the rate of "vector production," lest the pipeline need to be elastic nearly without limit. There is a Vector FIFO 45 at the output of the Address Mapper 29 discussed below, and it serves as an elastic capacity in the pipeline. The signal VEC_FIFO_FULL is used to prevent overrunning the limited number of stages in the pipeline, by causing a temporary cessation in the production of new vectors at the head end of the pipe.

To continue, the (three times sixteen equals forty-eight bits of) X, Y and Z address components 27 are applied to an Address Mapper 29, whose output is a selected-in-advance nearly arbitrary rearrangement of the address values in the ordered forty-eight bit address space. As a point of departure for appreciating this, suppose for a moment that the Address Mapper 29 were a memory that fully populated a forty-eight bit address space, and that it held a forty-eight bit value at each address. (Temporarily never mind that such a memory would --today anyway-- be size of a large refrigerator.) Given such a memory, a look-up table could be implemented that could map any applied address into another, arbitrarily selected, forty-eight bit value which could then be used as a replacement address. The reason that such address mapping is desirable is that the X, Y and Z address components generally have useful meaning in the context of a particular DUT's internal architecture, which is most likely not implemented with one big linear decoder. The notions of rows, columns and layers, block or pages may be very useful to the Test Engineer, and failures that occur in locations that are physically close together may involve corresponding closeness in their X, Y and Z addresses. Such patterns in the test results can be valuable in appreciating what is wrong and in trying to fix it, whether at a design level or at a production level of reprogramming a part to shunt a defective section's operation with that of a spare section. Two issues arise from such thinking. The first is paring the forty-eight bits down to the actual number of bits (say, thirty-two, or perhaps sixteen) to be applied to the DUT. We shall shortly briefly mention how the paring down is done, and it is largely a matter of taking this many bits from X, that many from Y and the rest from Z. But not entirely, and this is the second issue, because certain addresses might lie within circuitry that is a left-for-right (or left-for-right and top-for bottom) mirror image of another section of circuitry. This has the effect of rearranging what the bits mean, as far as what sequential address values are in physical order within that circuitry. This chip layout property may occur many times, and it may well be the case that how one group of bits for, say, Y, are interpreted, may depend upon the accompanying value of some other, say, Z bits. The address mapper 29 is provided to allow the raw X, Y and Z addresses to be "repackaged," as it were, to reflect this sort of thing for the benefit of those who would test memories having such internal architectural arrangements. As to how its actually done, the Address Mapper 29 is constructed of a fairly large number of interconnected multiplexers. It cannot implement the completely arbitrary look-up table behavior of a fully populated memory decode scheme as was temporarily assumed above for purposes of explanation. It can however, rearrange sub-fields of the X, Y and Z address components as needed, particularly since there is yet another mechanism that will do the paring down from forty-eight bits to the actual number needed. The Address Mapper 29 also contains three sixteen bit (address) look-up tables that allow it to perform limited arbitrary mapping within local ranges.

The mapped address output 30 of the Address Mapper 29 is applied as an address to an Aux RAM 31 and to an Error Catch RAM 32, which, while having separate functions, may nevertheless be implemented selectable partitions in one larger overall RAM. The mapped address output 30 is also applied as one input to an Addr. Bit Select circuit 37, which is described below.

Consider the Aux RAM 31. Its function is to retain data patterns 33 and addresses 34 that can be applied to the DUT. These are logically separate outputs from the Aux RAM 31, since they are treated somewhat differently and used in different places. (The AUX RAM 31 is not a dual "port memory", but is preferably of several banks whose outputs are applied to MUX's.) In keeping with this, it may be that Stored Data 33 is kept in one bank or range of addresses of the Aux RAM 31, while Stored Addresses 34 are kept in another. Also, we have not shown an explicit mechanism for writing to the Aux RAM 31. That is accomplished by an addressed bus operation initiated by a Test Site Controller 4 at the behest of the program it is executing. (There is an "under the floorboards," as it were, "utility services" bus called the "Ring Bus" [not shown -- as it would clutter the drawing immensely] that goes to just about everything in Figure 2.)

The Error Catch RAM 32 is addressed by the same address that is applied to the Aux RAM 31, and it either stores or retrieves information about errors, which operations are performed in conjunction with a Post Decode Circuit, to be discussed later. As with the paths 33 and 34 from the Aux RAM 31, paths 61 (into the Error Catch RAM) and 62 (from the Error Catch RAM) are preferably MUX'ed outputs from a multi-bank memory (the Error Catch RAM 32), in accordance with configuration information distributed by the Ring Bus (not shown).

Note that the Data MUX 35 has as inputs the STORED DATA output 33 from the Aux RAM 31 as well as data 28 from the registers DH and DL in the collection 24 of ALU's. The Data MUX 35 selects which of these inputs (28, 32) to present as its output 38, which is then applied as one of two vector components to a Transmit Vector Mapper / Serializer / Receive Vector Compare Data Circuit 40 (the other component is the output 39 of the Addr. Bit Select circuit 37).

Circuit 40 can perform three functions: assemble vector components (38, 39) into an ordered logical representation an entire vector that is to be applied (transmitted) to the DUT; apply an arbitrary dynamic correspondence (mapping) between the ordered bits of the logical representation of the transmit vector and the actual physical channel number of the Pin Electronics (i.e., which probe tip) will contact the DUT on behalf of that signal (i.e., that bit in the vector); and, cooperate with the compiler in the division of an entire logical vector into pieces to be applied separately and in order (serialization) for DUT's that admit of such a thing. Which of these functions is performed is determined by control signals from an SRAM 41, which is also addressed in accordance with a field in the two hundred and eight bit instruction fetched by the Micro-Controller Sequencer 19. The output of Circuit 40 is an up to sixty-four bit vector 44 that is applied to a Vector FIFO 45, which when full generates the signal VEC_FIFO_FULL 26, whose meaning and use was discussed above. The vector at the top of the Vector FIFO 45 is removed therefrom upon receipt of a signal VEC_FIFO_UNLOAD 47 that originates at a Period Generator 49 (to be discussed shortly). Such removed vectors (46) are applied to a Timing / Formatting & Comparison circuit 52 that is connected to the DUT via the associated instance of Pin Electronics 9. That is, each instance of Pin Electronics 9 receives Transmitted & Received Vectors 7 and Pin Electronics configuration information 8 from its associated Timing / Formatting & Comparison circuit 52.

The Timing / Formatting & Comparison circuit 52 has an Internal SRAM 54 addressed by the same Instruction Address ("A" in the small circle) as is the Program SRAM 20 of the Micro-Controller Sequencer 19. (An External DRAM 53 may be used in place of the Internal SRAM 54.) The Internal SRAM 54 (or external DRAM 53) assists in the production of Drive and Comparison cycles. Drive cycles apply a transmit vector to the DUT. Comparison cycles receive a vector presented by the DUT and examine it to determine if it matches previously supplied comparison data. Both Drive and Comparison cycles are adjustable as to their duration, whether and when a load is applied, and when data is latched or strobed. The comparison produces a sixty-four bit value 56 that is applied to a Receive Vector Reverse Mapper / Deserializer 57, whose function may be considered to be the logical inverse of circuit 40. (The operation of circuit 57 is controlled by an SRAM 58 that corresponds to the control of circuit 40 by SRAM 41.) In turn, the output 59 of circuit 57 is applied to the Post Decode circuit 60. At present, it is sufficient to say that the Post Decode circuit 60 can inspect via programmatic criteria both incoming error information 59 and (previously) stored error information 60 (stored in Error Catch RAM) to produce condensed and more readily interpretable error information which may then by stored back into the Error Catch RAM 32 via path 61. An example would be to create a count of how many times there was an error within a particular range of addresses, which information may be useful in deciding when to attempt to engage in on-chip repair by enabling substitute circuits.

We turn now to the Period Generator 49 and its associated Timing SRAM 51. These respond to an eight bit signal T_SEL 43 that, for each two hundred and eight bit instruction fetched by the Micro-Controller Sequencer 19, determines a duration for the associated operation of the Timing / Formatting & Comparison circuit 52. T_SEL 43 is member of the Various Control Values & Instructions 42 that are represented by the different fields within the fetched instruction. As an eight bit value it can represent or encode two hundred and fifty-six different things. In this case those "things" are twenty-eight bit values stored in the Timing SRAM 51 and that are addressed by T_SEL. Each addressed twenty-eight bit value (23) specifies a desired duration with a 19.5 picosecond resolution. The sequence of accessed twenty-eight bit duration values (23) is stored in a Period FIFO 50 so that the individual members of that sequence will be retrieved and applied in synchronism with the retrieval of their intended corresponding vector, which is stored in the Vector FIFO 45.

A coarse timing value field in the oldest entry in the FIFO 50 conveys duration information with a resolution of 5 nsec, and produces therefrom a signal VEC_FIFO_UNLOAD 47 that transfers the next transmit vector from the Vector FIFO 45 to the Timing / Formatting & Comparison circuit 52. A companion signal TIMING REMAINDER 48 is also applied to circuit 52. It is there that the ultimate resolution to 19.5 picoseconds is accomplished.

With specific reference to Figure 2 of the drawings, there is shown a DUT tester 6, which is an application specific integrated circuit (ASIC) comprising a primary memory 20 connected to a sequencer 19. The primary memory 20 comprises a 4k vector SRAM having a 208-bit width. Each vector represents a single program instruction to the sequencer 19 and surrounding circuitry. Accordingly, the terms test vector and instruction are used interchangeably herein. The primary memory 20 stores a plurality of the program vectors, or instructions. The sequencer 19 accesses certain ones of the program instructions in the primary memory 20 to execute a test pattern. The sequencer 19 sequentially accesses the program instructions and calculates the address location for the next instruction. Each program instruction is processed by the DUT tester 6 to generate electrical control signals that are fed into a timing control and analog pin circuitry 52 to exercise the device under test (DUT) 14.

As part of a program instruction, the disclosed tester is able to perform a calculation in each of the eight 16-bit arithmetic elements 24, or ALUs, in a single vector. A major component part of each arithmetic element is a conventional arithmetic logic unit (ALU), hence the interchangeability of the terms "arithmetic element" and "ALU". Each ALU is an arithmetic element that operates independently of the others and is further able to conditionally perform each calculation, each calculation depending upon the status of one of a number of available status flags. A test developer may want to write a test pattern specifying one or more calculations using an "if...then", an "if...then...else", or an unconditional construction. In order to maintain DUT timing integrity, the unconditional or conditional calculation must occur within a single vector.

With specific reference to Figure 3 of the drawings, there is shown a further detail of the eight ALUs 24, X, Y, Z, DL, DH, A, B, and C, and surrounding logic that supports conditional calculations for the X and Y ALUs 302, 304 respectively. The X and Y ALUs and supporting logic for conditional calculations is similar and, therefore, they are shown on the same drawing. Each ALU 24 generates three status flags 306, a min, a max, and a match status flag. Specifically, the X ALU 302 generates xmin 308, xmax 310, and xmatch 312 status flags. The Y ALU 304 generates ymin 314, ymax 316, and ymatch 318 status flags. The DL, DH, A, B, and C ALUs generate similar status flags 306 as well. The xmatch 312 and ymatch 318 status flags are conjunctively combined using an AND gate 320 together to generate another status flag 306, an xymatch 322 status flag. The Z-ALU 334 generates zmatch 324, zmin 326, and zmax 328. The xmatch 312, the ymatch 318, and the zmatch 324 status flag are conjunctively combined using AND gate 330 to generate an xyzmatch 332 status flag. The DL and DH ALUs 336, 338 generate the same three status flags, but of the status flags 306 that are generated, the X ALU 302 utilizes only the dlmatch 340 and dhmatch 342 status flags. The dlmatch 340 and dhmatch 342 status flags are conjunctively combined in AND gate 344 to generate dldhmatch 346 status flag. The A 348, B 350, and C 352 ALUs generate similar min, max, and match flags that are nine available flags 354. The available flags 354 are input into an available flag selector 356, which is a 9x1 multiplexer that selects one of the available flags 354 as the one that is presented as one of the status flags 306 for the X ALU 302. A flag configuration register 358, APG_GEN_CONFIG, is located within the sequencer 19 circuitry. Bits 8 through 11 of the flag configuration register 358 may be programmed to a value, the value of those bits determining the selection of the status flag 306 from one of the available flags 354. Fifteen of the status flags 306 as well as a fixed grounded input 362 are input into a status flag selector 360 to make sixteen selections for the status flag selector 360. The status flag selector is a 16x1 multiplexer. A condition X field 364 is four bits in the 208-bit instruction word that is stored in the program SRAM 20. The value in the condition X field 364 determines which one of the status flags 306 that are input into the status flag selector 360 is selected as an instruction select X 366. The instruction select X 366 determines one of two selections in an instruction selector 368. The instruction selector 368 receives two possible instruction codes. A first X alternative instruction 370 and a second X alternative instruction 372 are each 6-bits wide. Each instruction is encoded in an X instruction field, which is a portion of the 208-bit instruction word from the program SRAM 20 containing the conditional calculation. Depending upon the state of the selected status flag, which is the instruction select 366, either the first alternative instruction 370 or the second alternative instruction 372 are input into the X ALU 302 for execution. The number of bits in the disclosed embodiment that are used to support the X ALU 302 conditional calculations, therefore, is 16 bits total. As one of ordinary skill in the art appreciates, more or fewer bits may be used for any one of the X condition field 364 and the first and second X alternative instructions 370, 372 to provide more or less options in terms of the number of status flags used and magnitude of the ALU instruction set.

The paragraph above describes the logic supporting conditional calculations within the X ALU 302. Each of the ALUs, however, supports its own conditional calculation using another portion of the 208-bit instruction word, which can be executed simultaneously with calculations in the other ALUs 24. The logic supporting conditional calculations within the Y ALU 304 is also shown in Figure 3 of the drawings. A Y supported status flag selector 384 receives 14 of the same status flags 306 as those used in the X supported status flag selector 360. The one exception is the status flag 306 that is selected from a plurality of available flags 354. A Y supported available flag selector 374 accepts the same available flags 354 comprising the min, max, and match flags from each of the A 348, B 350, and C 352 ALUs. Different bits from the available flag configuration register 358 select which one of the available flags 354 is to be used as one of the status flags 306 for the Y ALU 304. This renders the status flag selection from the available flags 354 independently programmable.
Specifically, bits four through seven of the available flag configuration register 358 are input into the Y supported available flag selector 374. A condition Y field 386 determines the selection by the status flag selector 384 of the status flag 306 that is to be the Y instruction select 382. The Y instruction select 382 is used to determine a selected output of a Y instruction selector 380. The Y instruction selector 380 receives a first Y alternative instruction 376 and a second Y alternative instruction 378, each 6-bits wide, from a Y instruction field in the 208-bit instruction word 22 from the program SRAM 20. The Y instruction field is in a different field but in the same program instruction word 22 as the X instruction field. Depending upon the state of the Y selected status flag, which is the Y instruction select 382, either the first Y alternative instruction 376 or the second Y alternative instruction 378 is input into the Y ALU 304 for execution.

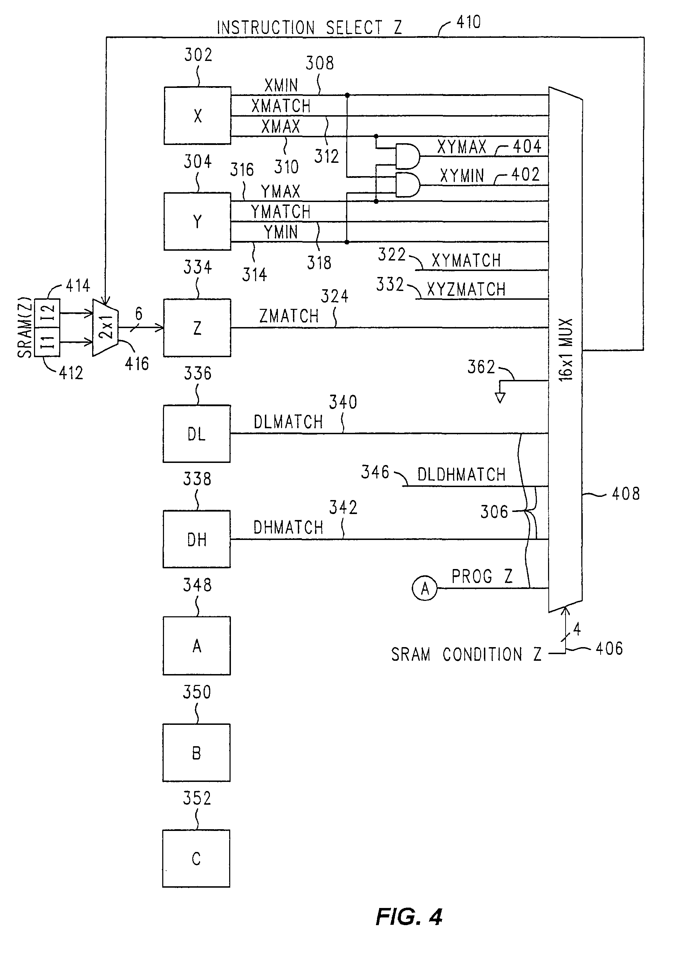

With specific reference to Figure 4 of the drawings, there is shown the Z ALU 334 and logic supporting the Z ALU conditional calculation process. The Z ALU 334 uses some of the same status flags 306 as are used in the X and Y supported conditional calculations. In the disclosed embodiment, the Z ALU 334 also uses sixteen status flags 306. Those status flags 306 that are used and are in common with the X and Y ALUs are xmin 308, xmax 310, xmatch 312, ymin 314, ymax 316, ymatch 318, zmatch 324, xymatch 322, xyzmatch 332, dlmatch 340, dhmatch 342, didhmatch 346, and the fixed zero value 362. In addition, the Z ALU 334 also uses a status flag that is xmin 308 and ymin 314 conjunctively combined to be xymin 402 and a status flag that is xmax 310 and ymax 316 conjunctively combined to be xymax 404. With reference to Figure 3 of the drawings, the Z ALU 334 also uses a status flag 306 selected from one of the available flags 354. A Z supported available flag selector 388 receives the nine available flags 354 and selects one of them based upon a value in bits zero through three of the available flag configuration register 358, APG_GEN_CONFIG[0:3]. See connector (A) shown in both Figures 3 and 4 of the drawings. With reference back to Figure 4 of the drawings, a Z condition field 406 determines which one of the status flags 306 that are input into a Z supported status flag selector 408 is used as a Z instruction select 410. The Z-instruction select 410 is used to determine the selection between a first Z alternative instruction 412 and a second Z alternative instruction 414. Both the first and second Z alternative instructions are input into a Z instruction selector 416. Depending upon the value of the Z instruction select 410, one of the first or second Z alternative instructions is input into the Z ALU for execution.

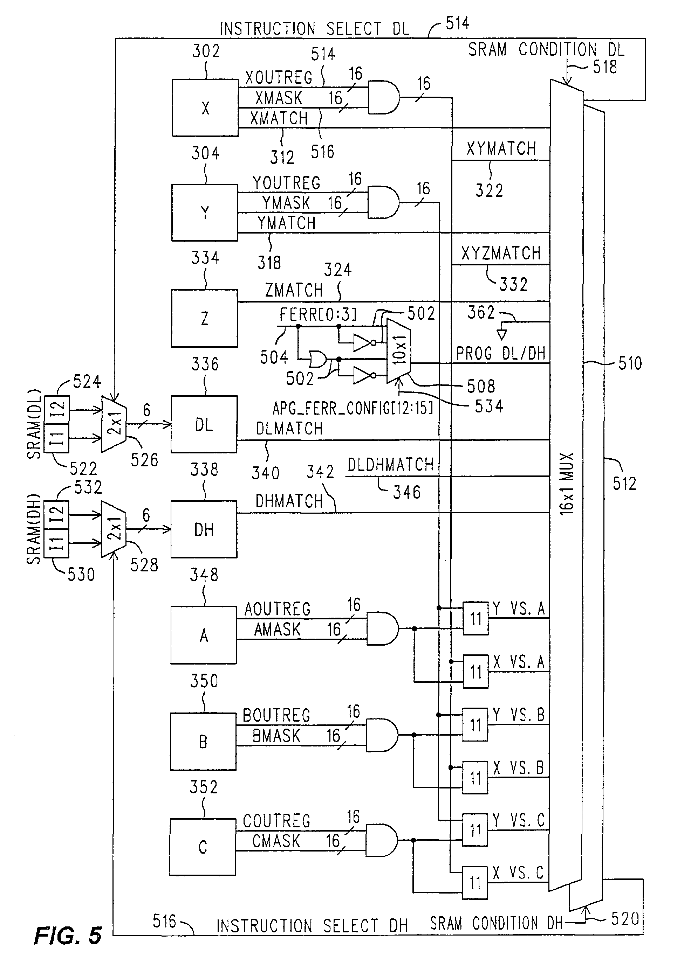

With specific reference to Figure 5 of the drawings, there is shown The DL (data low) and DH (data high) ALUs 336, 338 respectively, with logic to support their conditional calculation. Each of the DL and DH ALUs has identical logic and inputs supporting the conditional calculation process. The DL/DH ALUs use the following same status flags 306 as used by the X and Y ALUs; xmatch 312, ymatch 318, xymatch 322, xyzmatch 332, zmatch 324, dlmatch 340, dhmatch 342, dldhmatch 346, and the fixed value 362 wired to ground. The remaining status flags 306 are different from any of the X, Y, or Z ALUs. One of the status flags 306 may be selected as one of ten functional error flags 502. Four of the ten functional error flags are Ferr bits zero through three, Ferr[0:3]. Each one of the Ferr[0:3] bits are set to a positive value by the timing/ formatting and comparison block 52 if an unexpected result is received from the DUT 14. There are four Ferr error flags 504 received from the timing/formatting and comparison block, each flag representing a functional error on one of a pre-programmed number of channels at the DUT pin electronics 14. Accordingly, each one of the Ferr flags 504 is independently set. All of the four Ferr flags 504 are logically ORed together to generate a fifth one of the ten functional error flags. Each of the five resulting functional error flags is inverted to generate a total of the ten functional error flags 502. A functional error flag selector 508 selects one of the ten functional error flags 502 to be received as one of the status flags 306 used by DL and DH supporting status flag selectors 510, 512. Four bits in a functional error configuration register 534, APG_FERR_CONFIG[12:15] determine the selection by the functional error flag selector 508 of which one of the ten functional error flags is used as one of the status flags 306 that is input into the DL and DH status flag selectors 510, 512. Unique to the DL and DH ALUs 336, 338 is the result of compare between an output register value and a mask value for a first one of the ALUs and an output register value and a mask value for a second one of the ALUs. Specifically, a 16-bit X ALU output register value 514 is bit-wise logically ANDed with a 16-bit X mask register 516. This operation shall be referred to as an ALU masking operation. The Y ALU 304, A, B, and C ALUs 348, 350, and 352 all have similar ALU masking operations and with independent constructs. The 16-bit output of the logical AND operation is bit-wise compared to the 16-bit output of another one of the logical AND operations for another one of the ALUs and results in a bit indicating a match or no-match value of all of the 16-bits. The match/no-match value is another one of the status flags. The available combinations as shown in Figure 5 include, the X ALU masking operation vs. the A ALU masking operation, the X ALU masking operation vs. the B ALU masking operation, the X ALU masking operation vs. the C ALU masking operation, the Y ALU masking operation vs. the A ALU masking operation, the Y ALU masking operation vs. the B ALU masking operation, and the Y ALU masking operation vs. the C ALU masking operation. Of the status flags 306 that are used by the DL and DH ALUs 336, 338, one of them is selected by each of the DL and DH status flag selectors 510, 512 respectively to reflect the DL and DL instruction selects 514, 516 respectively. A DL condition field 518 is part of the 208-bit program instruction word 22 and serves to determine the selection made by the DL instruction selector 526. The DL instruction select 514 determines which one of first and second DL alternative instructions 522, 524 is sent to the DL ALU 336 for execution. The first and second DL alternative instructions 522, 524 are encoded in a DL instruction field, which is a portion of the 208-bit program instruction word 22 stored in the program SRAM 20. Both of the first and second DL alternative instructions 522, 524 are input into a DL instruction selector 526 for determination by the DL instruction selector 526 of which one of the first and second DL alternative instructions 522, 524 is executed by the DL ALU 336. Similarly, a DH condition field 520 is part of the 208-bit program instruction word 22 and serves to determine a selection made by the DH instruction selector 528. The DH instruction select 528 determines which one of first and second DH alternative instructions 530, 532 is sent to the DH ALU 338 for execution. The first and second DH alternative instructions 530, 532 are encoded in a DH instruction field, which is a portion of the 208-bit program instruction word 22 stored in the program SRAM 20. Both of the first and second DH alternative instructions 530, 532 are input into the DH instruction selector 528 for determination by the DH instruction selector 528 of which one of the first and second DH alternative instructions 530, 532 is executed by the DH ALU 338.

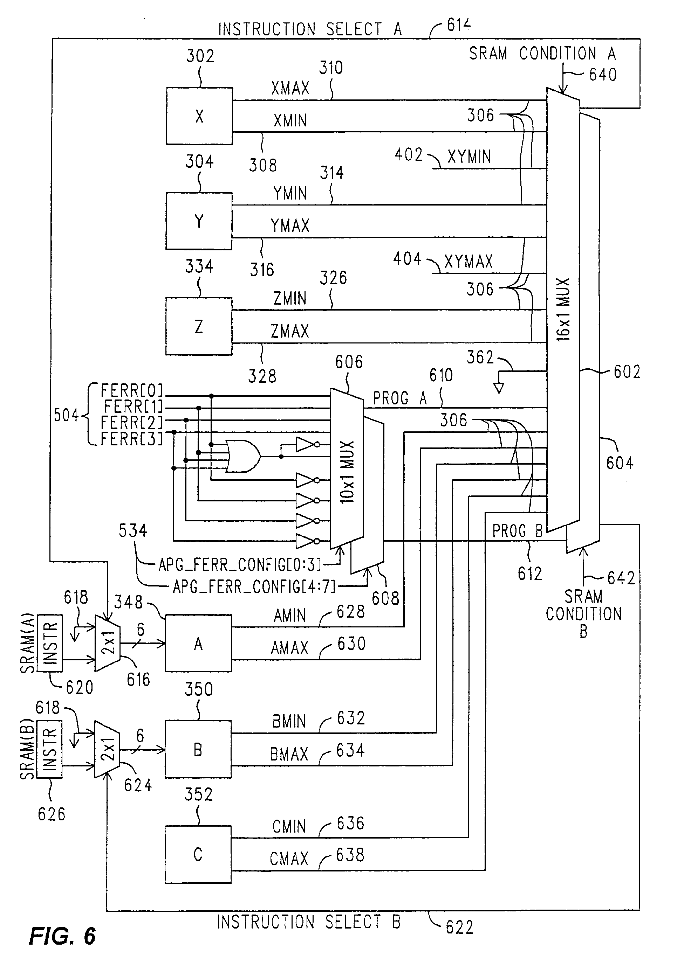

With specific reference to Figure 6 of the drawings, there is shown a block diagram representing the A and B ALUs 348 and 350 and logic to support the conditional calculation for those ALUs. Similar to the previous figures, sixteen status flags 306 are input into A and B status flag selectors 602, 604 respectively. There are nine status flags used by the A and B ALUs that are common to the X 302, Y 304, and Z 334 ALUs include; xmin 308, xmax 310, ymin 314, ymax 316, xymin 402, xymax 404, zmin 326, zmax 328, and the fixed value 362 wired to ground potential. The A and B ALUs 348, 350 also use the amin 628, amax 630, bmin 632, bmax 634, cmin 636, and cmax 638 flags from the A, B, and C ALUs 348, 350, and 352, respectively. Each one of the A and B ALUs 348 and 350 also have a programmable status flag 610 and 612 respectively selected from one of flue ten functional error flags 504. The A programmable status flag 610 utilizes an A supported functional error flag selector 606 with an output determined by bits zero through three of the functional error flag configuration register 534, APG_FERR_CONFIG[0:3]. The B programmable status flag 612 utilizes a B supported functional error flag selector 608 with an output determined by bits four through seven of the functional error flag configuration register 534, APG_FERR_CONFIG[4:7]. A condition A field 640 in the 208-bit instruction word 22 stored in the program SRAM 20 determines which one of the status flags 306 is selected by the A supported status flag selector 602 as the A instruction select 614. The A instruction select 614 determines which input into an A supported instruction selector 616 is chosen as the instruction for execution by the A ALU 348. In the disclosed embodiment, the tester supports only unconditional and simple conditional calculations for the A ALU 348. Accordingly, the A supported instruction selector 616 receives an A ALU conditional instruction 620 and fixed value 618 wired to ground potential. The A ALU conditional instruction 620 is selected by the A supported instruction selector 616 to be executed by the A ALU 348 if the A instruction select 614 is true and the hold or no-operation instruction is selected if the A instruction select 614 is false. A condition B 642 field in the 208-bit instruction word 22 stored in the program SRAM 20 determines which one of the status flags 306 is selected by the B supported status flag selector 604 as the B instruction select 622. The B instruction select 622 determines which input into a B supported instruction selector 624 is chosen as the instruction for execution by the B ALU 350. In the disclosed embodiment, the tester supports only unconditional and simple conditional calculations for the B ALU 350. Accordingly, the B supported instruction selector 624 receives a B ALU conditional instruction 626 and the fixed value 618 wired to ground potential. The conditional instruction 626 is selected by the B supported instruction selector 626 to be executed by the B ALU 350 if the B instruction select 622 is true and the hold or no-operation instruction is selected if the B instruction select 622 is false.

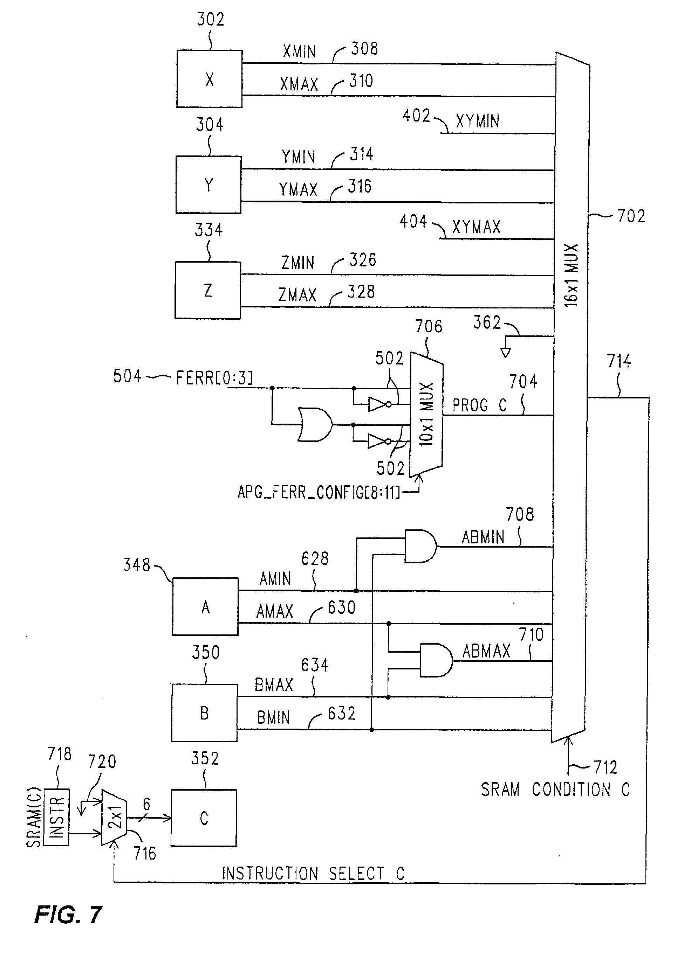

With specific reference to Figure 7 of the drawings, there is shown a block diagram representing the C ALU 352 and logic supporting the conditional calculation for it. Similar to the previous figures, sixteen status flags 306 are input into a C status flag selectors 702. There are thirteen status flags used by the C ALU 352 that are common to the A and B ALUs 348, 350 shown in Figure 6 of the drawings. Those status flags that are common include the xmin 308, xmax 310, ymin 314, ymax 316, zmin 326, zmax 328, the fixed value 362 wired to ground potential, amin 628, amax 630, bmin 632, bmax 634, cmin 636, and cmax 638 flags. The C ALU 352 also has a programmable status flag 704 selected from one of the ten functional error flags 502. The C programmable status flag 704 utilizes a C supported functional error flag selector 706 with an output determined by bits eight through eleven of the functional error flag configuration register 534, APG_FERR_CONFIG[8:11]. The C ALU also utilizes the conjunctive combination of the amin 628 and bmin 632 status flags to generate an abmin 708 status flag and the conjunctive combination of the amax 630 and bmax 634 status flags to generate an abmax 710 status flag. A condition C field 712 in the 208-bit instruction word 22 stored in the program SRAM 20 determines which one of the status flags 306 is selected by the C supported status flag selector 702 as the C instruction select 714. The C instruction select 714 determines which input into a C supported instruction selector 716 is chosen as the instruction for execution by the C ALU 352. In the disclosed embodiment, the tester supports only unconditional and simple conditional calculations for the C ALU 352. Accordingly, the C supported instruction selector 716 receives a C ALU conditional instruction 718 and fixed value 720 wired to ground potential. The C ALU conditional instruction 718 is selected by the C supported instruction selector 716 to be executed by the C ALU 352 if the C instruction select 714 is true and the hold or no-opertation instruction is selected if the C instruction select 714 is false.

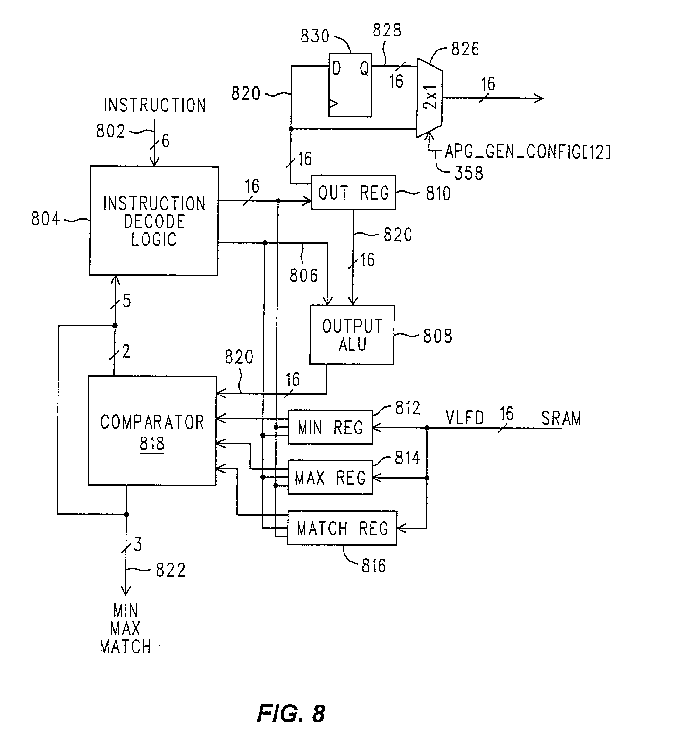

With specific reference to Figure 8 of the drawings, there is shown a simplified block diagram of a generic arithmetic unit, or ALU. Each one of the ALUs used in the disclosed embodiment is identical, figure 8 of the drawings being representative of all of them. Each functional block in Figure 8 of the drawings is being described in terms of its primary function. As one of ordinary skill in the art appreciates, additional logic in inherently incorporated into each one of the functional blocks, the reproduction of which is within the skill of such individual upon a reading of the present description. Each ALU receives an instruction 802 from each one of the instruction selectors 368, 380, 416, 526, 528, 616, 624 and 716. The instruction 802 is received by instruction decode logic 804 which generates a number of control signals 806 that cause the ALU to perform an operation as specified in the instruction 802. The actual operation is performed in a conventional output arithmetic logic unit, "output ALU" 808, generating an output value 820. Three comparison registers, a min register 812, a max register 814, and a match register 816 may be programmed with specific values via a 16-bit vlfd field in the 208-bit program instruction word 22. The programmed values in each one of the comparison registers 812, 814, 816 are input into a comparator 818 that performs a comparison operation against the output value 820. A result of the comparison operation sets the min, max and match flags 822. If the operation caused the output value 820 to be equal to or less than the value in the min register, the min flag is set. If the operation caused the output value 820 to be equal to or greater than the value in the max register, the max flag is set. If the operation caused the output value 820 to be exactly equal to the value in the match register, the match flag is set. Additional logic in the min and max register blocks also causes the output value to be set to the value in the min register if the operation results in an output value that begins at a value less than the max register and results in a value greater than the max register value (i.e. overflow). Similarly, the same logic causes the output value to be set to the value in the max register if the operation results in an output value that begins in a value greater than the min register value and results in a value less than the min register (i.e. underflow). In both cases, both the min and max flags are set simultaneously and underflow and overflow flags are sent from the comparator 818 to the instruction decode logic. The min, max, and match flags 822 are the same three flags that are referenced for each ALU in Figures 3-7 of the drawings. Conceptually, the instruction decode logic is a large case... select statement. Each case represents a different bit pattern for each one of the instructions 802 that is input into the instruction decode logic 804. All zeros in the instruction represents a hold or no operation condition in which case, no operation is performed and all values are held to the same value as they held in the previous vector. The value in the output register 810 comprises 16-bits of information that are output of the ALU block 24 shown in Figure 2 of the drawings. Specifically, each 16-bits of X, Y, an Z ALU 302, 304, 334 output comprises the forty-eight bits connecting the ALU block 24 and the address mapper block 29. Each 16-bits of DL and DH ALUs 336, 338 output comprises the thirty-two bits connecting the ALU block 24 and the data mux 35. The ALU also contains a programmable pre-generation and post-generation mode bit 824. The pre/post generation bit 824 is programmed via bit twelve of the status flag configuration register 358, APG_GEN_CONFIG[12]. In pre-generation mode, the output value 820 is available immediately and one vector ahead of the status flag value 822 that causes the conditional calculation. In post-generation mode, the output value is held off by a single cycle with the use of a delay latch 830. Accordingly, the output value 820 is available at the same time as the status flag value that causes the conditional calculation. A generation mode selector 826 receives both the immediately available output value 820 and a delayed output value 828 and the pre/post generation mode bit 824 determines which of the available or delayed output values 820, 828 is presented as the output of the ALU.

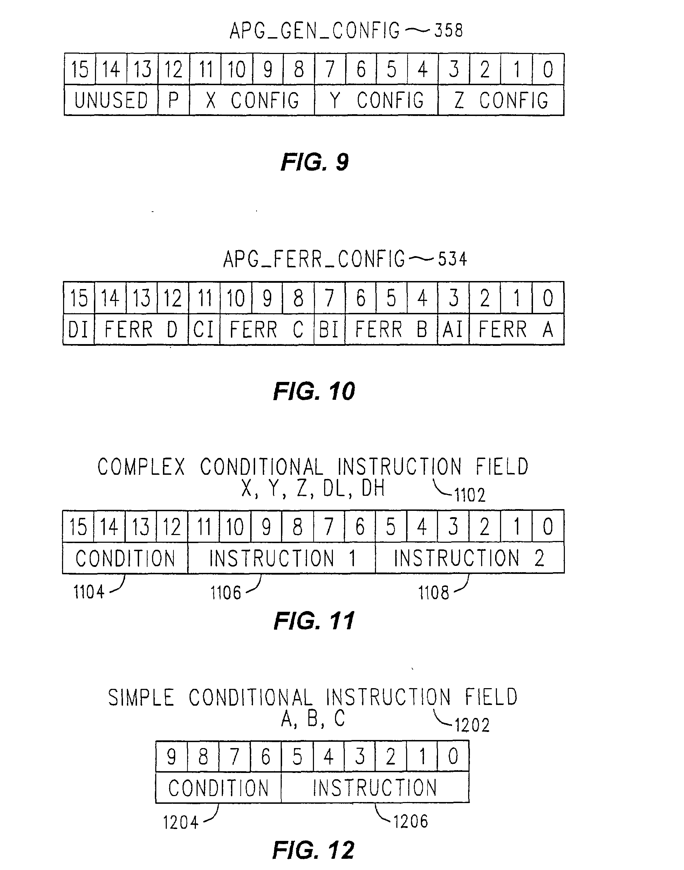

With specific reference to Figure 9 of the drawings, there is shown a representation of an embodiment of the available flag configuration register 358 in which bits zero through three program the Z supported available flag selector 388, bits four through seven program the Y supported available flag selector 374, and bits eight through eleven program the X supported available flag selector 356. Bit twelve is the pre/post-generation mode selector bit.

With specific reference to Figure 10 of the drawings, there is shown a representation of an embodiment of the functional error flag configuration register 534 in which bits zero through three program the A supported functional error flag selector 606. Bit three of the functional error flag configuration register 523 is used to specify whether to perform the instruction on the presence of a functional error or the absence of a functional error. Similarly, bits four through seven program the B supported functional error flag selector 608, bit seven indicating whether to perform the instruction on the presence or absence of a functional error, bits eight through eleven program the C supported functional error flag selector 706 bit eleven indicating whether to perform the instruction on the presence or absence of a functional error, and bits twelve through fifteen program the DL/DH supported functional error flag selector 508, bit fifteen indicating whether to perform the instruction on the presence or absence of a functional error.

With specific reference to Figure 11 of the drawings, there is shown a representation of the bit assignment for complex conditional instruction fields 1102 that direct execution of an unconditional, simple conditional, or complex conditional instruction. In the present embodiment only the X, Y, Z, DL and DH ALUs support complex conditional instructions. Each complex conditional instruction field is 16-bits wide and each one of the five ALUs that support the complex conditional calculation is associated with a unique one of the sixteen bit fields. Accordingly, the five ALUs mentioned use 60 bits in aggregate of the 208-bit program instruction word 22. The system supports unconditional and simple conditional instructions for the A, B, and C ALUs. The simple conditional instruction field is only 10 bits wide. An unconditional instruction is defined as one that causes an operation in one of the ALUs regardless of the state of any one of the status flags 306. A simple conditional instruction has an "if...then" format and causes an operation in one of the ALUs only if the state of the status flag is true. Otherwise, no operation is performed. A complex conditional instruction has an "if...then...else" format and performs a first operation if the state of the specified status flag is true and performs a second operation if the state of the specified status flag is false. As one or ordinary skill in the art appreciates, it is possible to support complex conditional instructions for all ALUs at the expense of a wider program instruction word 22.
The complex conditional instruction field is logically separated into a condition field 1104, bits twelve through fifteen, a first alternative instruction field 1106, and a second alternative instruction field 1108. The condition field 1104 specifies which one of the status flags 306 upon which the condition is based. The first alternative instruction field 1106 specifies a code that causes one of the ALUs to perform some operation if the selected status flag is true. The second alternative instruction field 1108 specifies a different code that causes the ALU to perform a different operation is the selected status flag is false. The complex conditional instruction format can also support the simple conditional instruction by including a code for the no operation or hold operation in the second alternative instruction field. An unconditional calculation is an instruction that causes one of the ALUs for perform a calculation such as an increment, decrement or shift. An unconditional instruction is simply programmed with a condition that is always true.
As an example of a complex conditional instruction for the X ALU 302, referring to Figure 3 of the drawings, the value in the condition field 364 for the complex conditional instruction that relates to the X ALU 302 is input into the A supported status flag selector 360. One of the status flags 306 is selected based upon the condition field value. The selected status flag is either true or false depending upon the status of the ALUs that originated the selected status flag. The selected status flag becomes the X instruction select 366. The state of the X instruction select 366 determines whether the first alternative instruction 370 or the second alternative instruction 372 is presented at the output of the instruction selector 368. Whichever instruction is selected is accepted by the instruction decode logic 804 in the X ALU 302. The instruction decode logic 804 generates the necessary control bits 806 to cause the desired operation to be executed. The result of the executed instruction is placed into the output register 810 and the min, max, and match flags 822 are set and latched into their logic for selection as status flags 306 for the next vector where an operation depends upon the value of one or more of the status flags 306.

With specific reference to Figure 12 of the drawings, there is shown a representation of the bit assignment for simple conditional instruction fields 1202 that direct execution of unconditional and simple conditional calculations. The simple conditional instruction field is ten bits wide and is a subset of the complex conditional instruction format shown as reference numeral 1102. The system supports simple conditional calculations for A, B, and C ALUs and represent thirty of the 208 bits in the 208-bit program instruction word 22. Together with the complex conditional calculation instructions, the conditional calculation fields account for 90 of the 208-bits in the program instruction word 22. Bits six through nine are the condition field 1204 and bits zero through five are the instruction field 1206. As an example and with reference to Figure 6 of the drawings, the value in the condition field 1204 for the A ALU instruction is input into the A supported status flag selector 602 as condition A 640. The value in the condition field selects one of the status flags 306 as the A instruction select 614. The A instruction select 614 determines whether the value in the instruction field 620 (generally shown as 1206 in Figure 12) is presented at the output of the A supported instruction selector 616 or a no operation value 618 which is a fixed value wired to ground which is the second input to the instruction selector 616.

A compiler that supports the complex conditional calculations accepts test pattern syntax and converts each line of program instruction to its comparable line of machine code. In an embodiment of a tester according to the teachings of the present invention, many tester instructions may populate a single program instruction or vector. A single program instruction can contain one calculation for each arithmetic element for a total of 8 instructions as well as others for example waveform types and device pin mappings, conditional and unconditional branches. The compiler also supports encoding for these other instructions that are not relevant to the present invention, and so, are not specifically discussed herein. However, it is interesting to note that the compiler processes all other instructions prior to complex conditional calculation encoding. As the compiler processes each instruction, the compiler removes the command from an instruction string that holds the instruction syntax simplifying the instruction string as the process proceeds.

The conditional calculations may be in an unconditional, complex or simple form depending upon the arithmetic element and test developer option. The X, Y, Z, DL, and DH arithmetic elements support all three forms. The arithmetic elements A, B, and C support only the unconditional and simple conditional forms. With specific reference to Figures 11 and 12 of the drawings, both forms of conditional instructions include a six-bit instruction field. Accordingly, each arithmetic element has up to sixty-four possible instructions. Only one of the sixty-four possible instructions may be executed for each arithmetic element in a single program instruction. The sixty-four possible instructions comprise a list of those instructions that are considered by the inventors to be those most useful in a specific embodiment of a tester. The specific instructions selected, however, are largely a matter of design choice. Of the sixty-four possible instructions, one instruction, having a "0x00" value, is a hold or no operation instruction in which all values are held during the cycle and no calculations are made. A first subset of the possible instructions includes instructions wherein only a single calculation is made. A second subset includes instructions wherein two calculations are made and a third subset includes instructions wherein three calculations are made. Each instruction has a unique six-bit instruction code associated with it. The compiler that supports the present invention assigns values to each of the condition and instructions fields for each arithmetic element. This totals 110 bits in aggregate of the 208-bit program instruction word 22.

The compiler for encoding unconditional and conditional calculations performs the following process for each ALU implicated in a program instruction. The compiler first sets the programmed instruction word to an instruction string variable and operates on it. As the compiler encodes portions of the instruction string into the appropriate machine code, it removes those portions that no longer need processing. The instruction string, therefore, is an unprocessed remnant of the original program instruction string after completion of prior compiler processes. This elimination process aids in the simplification of the process for encoding the complex conditional calculations.

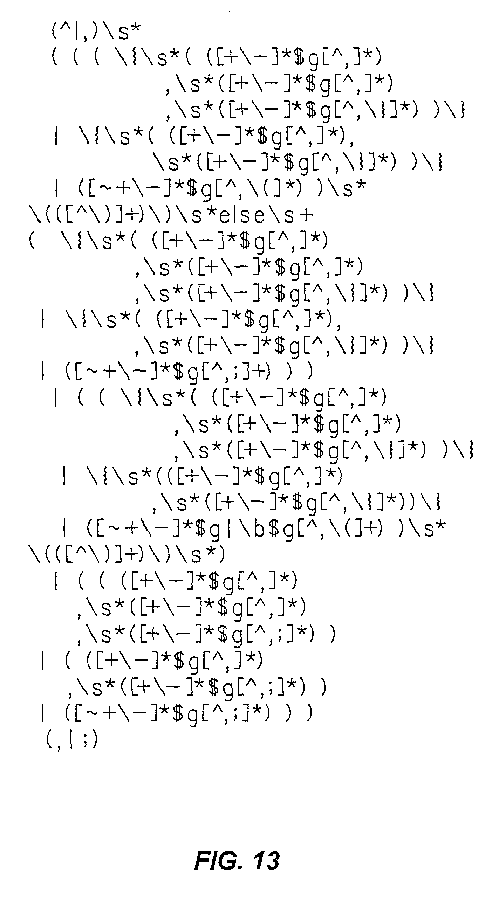

The compiler calls an expression identification subroutine for each arithmetic element by sending it a parameter with the arithmetic element name, in this case x, y, z, dl, dh, a, b, or c. The processing within the expression identification subroutine, therefore, operates on the entire instruction string, but identifies only the expression that relates to one of the arithmetic elements. A specific embodiment of the expression identification subroutine according to the teachings of the present invention uses Perl 5.004 software and its regular expression syntax to isolate the different formats of complex conditional instructions. With specific reference to Figure 13 of the drawings, there is shown a specific embodiment of the regular expression. An "if statement" in the expression identification subroutine uses a regular expression to first identify whether any expression is used for the specific arithmetic element. If not, the subroutine calls another routine to assign the no operation or hold instruction for all conditions to the associated instructions field and the subroutine completes for that arithmetic element. If an expression does exist within the program instruction string for the arithmetic element specified, the regular expression categorizes and isolates the format category in a first order. The format category indicates whether the expression is complex conditional, simple conditional or unconditional. The same "if statement" identifies in a second order the type of instruction or instructions included in the expression. The type category indicates whether the first alternative instruction is a single, double or triple operation instruction and whether the second alternative instruction is undefined, a single, a double, or a triple operation instruction. The result of the categorization and isolation step using the regular expression is a plurality of string variables set with those string fragments that are relevant to the categories shown in the following outline. There is a different plurality of string variables with defined values according to the type of expression evaluated. The following outline provides a list of the string variables that are defined as well as their relationship to the expression and the other string variables. The first level of the outline (i.e. 1,2,3) defines the expression format, the second level of the outline (i.e. 1.1, 1.2, 1.3, etc.) defines the expression type, and the third level of the outline (i.e. 1.1.1, 1.1.2, 1.2.1, 1.5.1, etc.) contains the individual instructions.
1 complex conditional instruction (entire phrase).
   1.1 first alternative instruction (if and only if it is a triple format).
      1.1.1 first portion of first alternative instruction if first alternative instruction is a triple instruction.
      1.1.2 second portion of first alternative instructions if the first alternative instruction is a triple instruction.
      1.1.3 third portion if the first alternative instruction is a triple instruction.
   1.2 first alternative instruction (if and only if it is a double format).
      1.2.1 first portion if first alternative instruction is a double instruction.
      1.2.2 second portion if the first alternative instruction is a double instruction.
   1.3 first alternative instruction (if and only if it is a single format).
   1.4 condition.
   1.5 second alternative instruction (if and only if it is a triple format).
      1.5.1 first portion of second alternative instruction if second alternative instruction is a triple instruction.
      1.5.2 second portion of second alternative instruction if the second alternative instruction is a triple instruction.
      1.5.3 third portion if the second alternative instruction if the second alternative instruction is a triple instruction.
   1.6 second alternative instruction (if and only if it is a double format).
      1.6.1 first portion if second alternative instruction is a double instruction.
      1.6.2 second portion if the second alternative instruction is a double instruction.
   1.7 second alternative instruction (if and only if it is a single format).
2 simple conditional instruction (entire phrase)
   2.1 instruction (if and only if it is a triple format).
      2.1.1 first portion of alternative instruction if instruction is a triple instruction.
      2.1.2 second portion of instruction if the instruction is a triple instruction.
      2.1.3 third portion if the instruction is a triple instruction.
   2.2 instruction (if and only if it is a double format).
      2.2.1 first portion if the instruction is a double instruction.
      2.2.2 second portion if the instruction is a double instruction.
      2.3 instruction (if and only if it is a single format).
      2.4 condition.
3 unconditional instruction (entire phrase)
   3.1 instruction (if and only if it is a triple format).
      3.1.1 first portion of instruction if instruction is a triple instruction.
      3.1.2 second portion of instruction if the instruction is a triple instruction.
      3.1.3 third portion if the instruction is a triple instruction.
   3.2 instruction (if and only if it is a double format).
      3.2.1 first portion if the instruction is a double instruction.
      3.2.2 second portion if the instruction is a double instruction.
   3.3 instruction (if and only if it is a single format).

Those string variables that are not relevant to the expression in the categorization steps are defined as a null value. For example, if the expression is a complex conditional instruction using a double instruction for the first alternative instruction and a single instruction for the second alternative instruction, only those string variables described in outline numbers 1, 1.2, 1.2.1, 1.2.2, 1.4, and 1.7 are defined. All other string variables are null values.

Each string variable is then checked against a null value to find those string variables that are defined and are therefore part of the expression to be encoded. Because of the way the string variables are assigned, a non-null value provides sufficient information about the expression so the operations on the expression may be organized according to what must be done to encode it. Each of the string variables are evaluated in the hierarchical order, in the order shown in the outline, using a series of if...then statements. First the string variable described in item 1 in the outline is evaluated. If the string variable is a non-null value, it is known that the expression is a complex conditional instruction (i.e. one that uses the if...then...else format). This fact obviates the need to evaluate the expression for simple conditional and unconditional formats. After the string variable evaluates positive for the complex conditional instruction, the first alternative instruction string variables are evaluated. In the case of a complex conditional instruction, only one of the string variables described in levels 1.1, 1.2, or 1.3 is defined. Depending upon whether the string variable contains a triple, double, or single instruction type, a different encoding subroutine is called. There are three encoding subroutines, each one being specific to the triple, double, or single instruction type. An appropriate one of the encoding subroutines is called sending the next level string variables as parameters. Each encoding subroutine uses a case...select statement or a look-up table to match the specific instruction(s) and reference a binary code associated with the match. The encoding subroutine returns the binary code for the instruction(s) that were in the expression. The compiler uses the returned binary value to encode the appropriate instruction field. If the first level string variable is a null, the string variable that is defined when the expression is a simple conditional instruction is evaluated in a similar fashion using the first and second level string variables. The same encoding subroutines are called using the third level string variables. As each expression is evaluated and encoded, the compiler removes the processed expression leaving the program instruction string remnant for further expression evaluation. If the expression is categorized as a complex conditional or a simple conditional, a condition variable (i.e. 1.4 and 2.4) is also evaluated. The condition field in a specific embodiment is four bits wide. Accordingly, there are a maximum of sixteen possible conditions. The condition field is encoded using a condition encoding subroutine that has a sixteen selection case...select statement for matching the condition specified in the string variable and returning the binary code to which it is associated.
Although preferred embodiments of the invention are described, they are illustrative only. Other embodiments and modifications of the invention are possible without departing from the spirit and scope of the appended claims.

## Claims

1. An apparatus for performing conditional calculations comprising:
an arithmetic element 302,
an instruction selector 368 receiving a plurality of instructions 370,372,
a plurality of status flags 306 reflecting a state of said apparatus,
a status flag selector 360 selecting one of said status flags 306 to generate an instruction select 366, said instruction select 366 determining which one of said plurality of instructions is executed by said arithmetic element 302.

2. An apparatus for performing conditional calculations as recited in claim 1 and further comprising a plurality of said arithmetic elements 302, 304, 334, 336, 338, 348, 350, 352, said plurality of said status flags 306 being generated by said plurality of said arithmetic elements.

3. An apparatus for performing conditional calculations as recited in any one of claims 1 or 2 wherein said arithmetic element is an arithmetic logic unit having at least one register therein 812, said register having a register value, said at least one of said status flags 822 reflects a value of a calculation by said arithmetic element against said register value.

4. An apparatus for performing conditional calculations as recited in any one of claims 1 through 3 wherein said arithmetic logic unit has at least first, second, and third registers 812, 814, 816 therein, each register having associated with it first, second, and third ones respectively of said status flags 822, said first status flag reflecting a different value if said calculation results in a value equal to or less than a value in said first register, said second status reflecting a different value if said calculation results in a value equal to a value in said second register, and said third register reflecting a different value if said calculation results in a value equal to or greater than a value in said third register.

5. An apparatus for performing conditional calculations as recited in any one of claims 1 through 4 wherein each said arithmetic element further comprises a result register 810, a delay element 830 and a delay selector 826, said delay element 830 accepting a value from said result register 810 and generating a delayed output 828, said delay selector 826 accepting said result register value and said delayed output, and a configuration register 358 providing a delay selection control 824.

6. An apparatus for performing conditional calculations as recited in any one of claims 1 through 5 wherein said instruction selector 360 receives first and second alternative instructions 370,372 for selection by said instruction select 366.

7. An apparatus for performing conditional calculations as recited in claim 8 and further comprising a sequencer 19 and a primary memory 20, said primary memory 20 storing instructions that are accessed by said sequencer 19 and wherein said first and second alternative instructions 370, 372 are presented to said instruction selector 360 from said primary memory 20.

8. An apparatus for performing conditional calculations as recited in any one of claims 1 through 7 and further comprising a sequencer 19 and a primary memory 20, said primary memory 20 storing a condition code 364, wherein said condition code 364 determines which one of said status flags 306 is generated as said instruction select 366.

9. An apparatus for performing conditional calculations as recited in any one of claims 1 through 8 wherein one of said status flags 306 presented to said status flag selector 364 is programmable and further comprising at least one additional arithmetic unit 348 generating a plurality of available flags 354, an available flag selector 356 receiving said available flags 354 and selecting one of said available flags 354 to be one of said status flags 306.

10. An apparatus for performing conditional calculations as recited in any one of claims 1 through 9 and further comprising a plurality of said instruction selectors 368, 378, one of said instruction selectors for each arithmetic element 302,304, and a respective plurality of status flag selectors 360, 384.
